# EUROPÄISCHE PATENTSCHRIFT

(11) **EP 2 567 406 B1**
(45) Veröffentlichungstag und Bekanntmachung des Hinweises auf die Patenterteilung: **29.07.2015**
(21) Anmeldenummer: 11718706.2
(22) Anmeldetag: 03.05.2011
(51) Int. Cl.: H01L 31/02, H02J 3/38, H02H 7/20

(54) **VERFAHREN ZUR BEGRENZUNG DER GENERATORSPANNUNG EINER PHOTOVOLTAISCHEN ANLAGE IM GEFAHRENFALL UND PHOTOVOLTAISCHE ANLAGE**
METHOD FOR LIMITING THE GENERATOR VOLTAGE OF A PHOTOVOLTAIC INSTALLATION IN CASE OF DANGER AND PHOTOVOLTAIC INSTALLATION
PROCÉDÉ POUR LIMITER LA TENSION DE GÉNÉRATEUR D'UNE INSTALLATION PHOTOVOLTAÏQUE EN CAS DE DANGER ET INSTALLATION PHOTOVOLTAÏQUE CORRESPONDANTE

(30) Priorität: 05.07.2010 DE 102010017747; 03.05.2010 DE 102010016753
(43) Veröffentlichungstag der Anmeldung: 13.03.2013
(73) Patentinhaber: SMA Solar Technology AG, 34266 Niestetal (DE)
(72) Erfinder: VICTOR, Matthias, 34266l Niestetal (DE); BETTENWORT, Gerd, 34119 Kassel (DE); GREIZER, Frank, 34260 Kaufungen (DE); HÄRING, Adrian, 34266 Niestetal (DE); LASCHINSKI, Joachim, 34134 Kassel (DE); ENGEL, Bernd, 38302 Wolfenbüttel (DE)
(74) Vertreter: Kleine, Hubertus
(86) Internationale Anmeldenummer: PCT/EP2011/057043
(87) Internationale Veröffentlichungsnummer: WO 2011/138319

(56) Entgegenhaltungen:
- EP-A1- 1 039 361
- EP-A2- 2 101 391
- WO-A1-2009/060273
- US-A1- 2009 141 522
- US-B1- 6 545 211

## Beschreibung

Die vorliegende Erfindung bezieht sich auf eine photovoltaische Anlage mit einer Vorrichtung zur Begrenzung der Spannung in einem Gefahrenfall. Insbesondere bezieht sich die Erfindung auf eine Vorrichtung, mit der sicher gestellt werden kann, dass Spannungen bzw. Spannungsdifferenzen in einer solchen Anlage einen Gefahrengrenzwert nicht übersteigen, wenn eine Gefahr für Menschen oder Sachwerte besteht oder bestehen kann. Weiterhin bezieht sich die Erfindung auf ein Verfahren, um eine Generatorspannung im Gefahrenfall zu begrenzen.

Mit der weiten Verbreitung von dezentralen Energieeinspeisern, insbesondere von Solaranlagen, die auf Hausdächern, Gewerbegebäuden oder im Freiland installiert sind, rückt das Problem immer mehr ins Bewusstsein, dass im Gefahrenfall wie Brand und Sturm oder bei Wartungsarbeiten eine zuverlässige Sicherung der spannungsführenden Teile dieser Anlagen jederzeit möglich sein muss. Dabei ist die Zugänglichkeit der Abschaltvorrichtungen sowie deren Wirksamkeit gerade im Gefahrenfall dadurch beeinträchtigt, dass bereits eingetretene Vorschäden wie Hitze- und Raucheinwirkung ein zuverlässiges und dauerhaftes Auslösen der Sicherungsmaßnahme oder ein Erreichen der Auslöseeinrichtungen unmöglich machen können. Als Folge können zum Beispiel Löschmaßnahmen am Dachstuhl eines brennenden Hauses nicht vorgenommen werden, wenn die Möglichkeit besteht, dass Feuerwehrmänner durch hohe Gleichspannungen einer möglicherweise noch betriebsfähigen photovoltaischen Anlage verletzt werden können.

Die Druckschrift US 2009/0141522 A1 beschreibt eine Photovoltaikanlage, bei der ein photovoltaischer Generator in mehrere Teilgeneratoren aufgeteilt ist, wobei jedem Teilgenerator ein generatornaher Gleichspannungswandler nachgeschaltet ist. Die Gleichspannungswandler sind ausgangsseitig in Serie geschaltet über Gleichspannungsleitungen mit einem entfernten Wechselrichter verbunden. Im Wechselrichter ist eine Schalteinrichtung angeordnet, die die Verbindung zwischen dem Eingang des Wechselrichters und einem im Wechselrichter angeordneten Zwischenkreis auftrennen kann oder über die der Zwischenkreis kurzgeschlossen werden kann. Bei Auftrennung der Verbindung können die Gleichspannungsleitungen jedoch nach wie vor mit hoher Gleichspannung durch den Generator beaufschlagt sein. Bei einem Kurzschließen des Zwischenkreises und der Gleichspannungsleitungen herrscht auf diesen zwar keine gefährdende Spannung vor, es kann jedoch auch keine Leistung vom Generator zum Wechselrichter übertragen werden.

Die Druckschrift EP 1 039 361 A1 offenbart ein weiteres Beispiel.

Zum Schutz von Menschen und zur Vermeidung von Sachschäden durch hohe Gleichspannungen einer photovoltaischen Anlage schlägt DE 102005018173 eine Vorrichtung vor, mit der mittels einer generatornah installierten Schutzvorrichtung der Generator der Anlage kurzgeschlossen wird. Nachteilig auch bei dieser Ausführung ist die Tatsache, dass keine Energieabgabe in das Gebäude und somit über einen an den Generator angeschlossenen Wechselrichter in ein Netz mehr möglich ist.

Die Druckschrift DE 102006060815 offenbart ein jeweils einem PV-Modul zugeordnetes Schaltelement, das derart angeordnet ist, dass im aktivierten Zustand des Schaltelements das zugeordnete Modul spannungslos ist. Das Schaltelement wird mittels eines auf die Gleichspannungs-Zuleitung aufmödulierten Hochfrequenzsignales aktiviert. Auch bei den in der DE 102006060815 dargestellten Lösungen ist keine Energieabgabe über einen Wechselrichter in ein Netz mehr möglich, da der Generator in allen offenbarten Ausführungsformen spannungsfrei geschaltet wird. Darüber hinaus erfordert das Anordnen eines Schaltelementes an jedem Modul innerhalb eines von gegebenenfalls mehreren Strings einen nicht unerheblichen Schaltungsaufwand.

Die Druckschrift WO 2009/060273 A1 beschreibt eine Photovoltaikanlage, bei der ein Photovoltaikgenerator in mehrere Teilgeneratoren aufgeteilt ist. Die Teilgeneratoren sind separat an eine Schalteinrichtung angekoppelt, die wiederum über Gleichstromleitungen mit einem Wechselrichter verbunden ist. Die Schalteinrichtung verbindet die Teilgeneratoren abhängig von der von ihnen bereitgestellten Spannung wahlweise in einer Reihen- oder einer Parallelschaltung mit dem Wechselrichter, um eine maximale Leistungsausbeute des Generators zu erzielen.

Es ist eine Aufgabe der vorliegenden Erfindung, eine Vorrichtung bzw. ein Verfahren zur Verfügung zu stellen, das zuverlässig und mit vertretbarem Aufwand die Möglichkeit eröffnet, in einem potenziellen Gefahrenfall die durch Generatoren einer photovoltaischen Anlage entstehenden Spannungen bzw. Spannungsdifferenzen in den elektrischen Leitungen der Anlage auf ein Maß zu begrenzen, das Maßnahmen zur Bekämpfung der Gefahr ermöglicht, ohne für die im Einsatz befindlichen Rettungskräfte ein Schadensrisiko darzustellen. Dabei soll es möglich sein, bei reduzierter Spannung weiterhin Energie über einen an den Generator angeschlossenen Wechselrichter in ein Netz einspeisen zu können.

Diese Aufgabe wird durch eine photovoltaische Anlage mit den Merkmalen des Anspruchs 1 und ein Verfahren mit den Merkmalen des Anspruchs 8 gelöst. In den auf diese Ansprüche zurück bezogenen Unteransprüchen sind weitere Ausführungsformen der Erfindung beschrieben.

Die erfindungsgemäße photovoltaische Anlage weist einen Wechselrichter zum Einspeisen der von einem Generator der Anlage erzeugten elektrischen Energie in ein Netz, insbesondere ein Wechselstromnetz auf. Hierbei wird der Generator in eine Anzahl von Teilstrings aufgeteilt, die durch eine über eine Steuereinrichtung angesteuerte Reihenschalteinrichtung in Serie geschaltet werden können. Die photovoltaische Anlage umfasst weiter eine über die Steuereinrichtung angesteuerte Parallelschalteinrichtung, mittels derer die einzelnen Teilstrings parallel zueinander geschaltet werden können. Die photovoltaische Anlage ist derart eingerichtet, dass im Gefahrenfall eine Reihenschaltung der Teilstrings aufgetrennt wird und die Teilstrings parallel geschaltet werden.

Die Teilstrings weisen jeweils eine Anzahl von Modulen oder einzelnen Solarzellen auf, die so konfiguriert sind, dass die Leerlaufspannung eines jeden Teilstrings einen Wert aufweist, der einen zum Beispiel vom Gesetzgeber bestimmten Gefahrengrenzwert nicht übersteigt. Im Gefahrenfall bewirkt die Reihenschalteinrichtung, dass die elektrische Verbindung zwischen den Teilstrings aufgetrennt wird, so dass Spannungen bzw. Spannungsdifferenzen in den elektrischen Verbindungen zwischen dem Wechselrichter und den Teilstrings den Gefahrengrenzwert nicht mehr übersteigen können.

Ein Teilstring besteht dabei üblicherweise aus in Reihe geschalteten Modulen, die wiederum in Reihe geschaltete Solarzellen umfassen. Je nach verwendetem Modultyp kann die Spannung des Moduls bereits so groß sein, dass bei einer Reihenschaltung zweier Module der Gefahrengrenzwert überschritten wird. In diesem Fall kann ein Teilstring auch aus einem einzelnen Modul bestehen. Ebenso kann ein Teilstring auch aus einer Parallelverschaltung mehrerer Strings bestehen, deren Spannung den Gefahrengrenzwert nicht überschreitet.

Der Gefahrengrenzwert kann regional einen unterschiedlichen, vorgeschriebenen Wert aufweisen, zum Beispiel eine Spannung von 120 V, es können aber auch abweichende Werte im Bereich zwischen 60 V und 150 V, also zum Beispiel 100 V, als Grenzwert vorgegeben werden.

In einer bevorzugten Ausführung der Erfindung weist der an den Wechselrichter angeschlossene Generator mindestens drei durch die Reihenschalteinrichtung in Serie zu schaltende Teilstrings auf. Auf diese Weise kann erreicht werden, dass die gesamte Generatorspannung im optimalen Betriebspunkt des Generators einen Wert größer als die Scheitelspannung des Netzes aufweist (z.B. 350 V), wodurch die Einspeisung in das Netz ohne den Einsatz eines Hochsetzstellers im Wechselrichter möglich wird. Gleichzeitig kann die Leerlaufspannung der einzelnen Teilstrings unter dem oben angegebenen Gefahrengrenzwert verbleiben. Bei drei Teilstrings ist es allerdings häufig erforderlich, den Generator oberhalb einer Spannung zu betreiben, bei der die elektrische Leistung des Generators maximal ist, um die Scheitelspannung des Netzes zu überschreiten. Daher kann es vorteilhaft sein, mindestens vier Teilstrings in Serie zu schalten, wodurch es möglich ist, den Generator im Arbeitspunkt maximaler Leistung zu betreiben, wobei die Leerlaufspannung der einzelnen Teilstrings unterhalb eines Gefahrengrenzwertes von 120 V verbleiben kann. Bei anderen Gefahrengrenzwerten ergibt sich entsprechend eine andere Anzahl von Teilstrings, ab der dieser Effekt erreicht werden kann.

Die Reihenschalteinrichtung kann hierbei eine Anzahl von Schaltern aufweisen, die über eine Steuereinrichtung derart ansteuerbar sind, dass sie in einem Betriebszustand der photovoltaischen Anlage eine elektrische Verbindung zwischen benachbarten Teilstrings herstellen, und im potenziell gefährlichen Zustand diese Verbindung auftrennen. Die Parallelschalteinrichtung kann ebenso wie die Reihenschalteinrichtung eine Anzahl von Schaltern aufweisen. Die Schalter in der der Reihenschalteinrichtung und in der Parallelschalteinrichtung können hierbei mechanische Schalter, zum Beispiel Relais, oder Halbleiter, insbesondere Leistungs-Halbleiter wie MOSFETs, IGBTs oder Thyristoren sein.

Durch eine Integration der Reihenschalteinrichtung und der Parallelschalteinrichtung in ein Gehäuse des Wechselrichters wird zum einen eine besonders einfache Installation der Sicherungsmaßnahme erreicht. Gleichzeitig wird die Zuverlässigkeit der Auslösung der Sicherungsmaßnahme im Gefahrenfall deutlich erhöht, insbesondere wenn alle zugehörigen Komponenten im Gehäuse des Wechselrichters angeordnet sind, wo sie zumindest eine erhebliche Zeitdauer vor Beschädigung durch Rauch- und Hitzeeinwirkung, aber auch vor den in Generatornähe typischen Witterungseinflüssen geschützt sind. Ebensogut können die Reihenschalteinrichtung und/oder die Parallelschalteinrichtung am Generator angeordnet sein, wobei die Schaltelemente der Reihenschalteinrichtung und/oder der Parallelschalteinrichtung entweder in einer gemeinsamen Einheit oder in separaten Einheiten an den Teilstrings oder auch zwischen den Teilstrings angeordnet sein können. Eine Anordnung am Generator bietet gegenüber der Anordnung im Wechselrichter den Vorteil, dass der Verkabelungsaufwand gegebenenfalls erheblich reduziert ist. Selbstverständlich können die Reihenschalteinrichtung und/oder die Parallelschalteinrichtung ebenso in einer separaten Box untergebracht sein, die sowohl wechselrichternah, als auch generatornah, als auch zwischen Generator und Wechselrichter platzierbar ist. Die Platzierung an geeigneter Stelle zwischen Generator und Wechselrichter ermöglicht dabei gegebenenfalls das Finden eines guten Kompromisses zwischen Schutz der Schalteinrichtung einerseits und Verkabelungsaufwand andererseits. Ferner wird hierdurch die Nach-, Auf- oder Umrüstung einer bestehenden Anlage ermöglicht.

Da viele photovoltaische Anlagen bereits mit Kommunikationstechnologie wie Powerline-Communication oder Funktechniken wie Bluetooth, ZigBee o.ä. ausgestattet sind, die einen Datenaustausch mit entfernten Kommunikationseinheiten herstellen können, ist auch die Erreichbarkeit der Steuer- und Auslöseeinrichtung, sowie die Rückmeldung der erfolgreichen Auslösung der Sicherungsmaßnahme in vorteilhafter Weise gewährleistet. Gleichzeitig ist es so möglich, mit einem einzigen Auslösesignal eine Vielzahl von photovoltaischen Anlagen zu sichern, was eine erhebliche Zeiteinsparung im Gefahrenfall zur Folge hat.

Die Parallelschalteinrichtung wird typischerweise betätigt, wenn die Reihenschalteinrichtung die elektrische Verbindung zwischen benachbarten Teilstrings aufgetrennt hat. In diesem Zustand ist ebenfalls sichergestellt, dass die in der Anlage auftretenden Spannungen bzw. Spannungsdifferenzen den Gefahrengrenzwert nicht übersteigen. Zusätzlich ist es in diesem Zustand möglich, auf einem niedrigeren Spannungsniveau des Generators weiterhin elektrische Leistung mittels des Wechselrichters in das Netz einzuspeisen. In diesem Fall ist es zur Einspeisung in das Netz notwendig, die Generatorspannung zunächst mittels eines Hochsetzstellers auf eine ausreichend hohe Gleichspannung umzusetzen. Beispielsweise kann auf diese Weise erreicht werden, dass die Einspeisung fortgesetzt werden kann, wenn längere Wartungsarbeiten im Bereich des Generators durchgeführt werden müssen, da ein Risiko für die die Wartung ausführenden Menschen durch die Reduktion der Generatorspannung ausreichend herabgesetzt werden kann. Die Fortführung der Einspeisung kann auch beim Auftreten von Fehlalarmen helfen, unnötige Einbußen der Energieausbeute der photovoltaischen Anlage zu vermeiden. Selbst im Brandfall würde eine erfindungsgemäße photovoltaische Anlage bei fortgeführter Einspeisung keine Gefahr für Rettungspersonal darstellen.

Es ist ebenfalls denkbar, die Schalter der Reihenschalteinrichtung und der Parallelschalteinrichtung gleichzeitig zu schließen, so dass die angeschlossenen Teilstrings in diesem Zustand kurzgeschlossen sind, wodurch ebenfalls eine Gefährdung durch die Generatorspannung ausgeschlossen ist.

Alternativ kann die Kurzschlussfunktion auch durch eine zusätzliche Kurzschließeinrichtung, die zwischen den elektrischen Zuleitungen zwischen Reihenschalteinrichtung und Wechselrichter angeordnet ist, erreicht werden.

Zusätzlich können Wechselrichter und Generator durch eine DC-Trenneinrichtung voneinander getrennt werden. Die Kurzschließeinrichtung und die DC-Trenneinrichtung können hierbei ebenfalls Schalter von den im Rahmen der Reihenschalteinrichtung aufgezählten Typen aufweisen.

Weiterhin kann die photovoltaische Anlage optional zusätzlich eine Erdschließeinrichtung umfassen, die ebenso wie die Reihenschalteinrichtung und die Parallelschalteinrichtung eine Anzahl von Schaltern aufweist, die derart konfiguriert sind, dass sie im geschlossenen Zustand mindestens einen Anschluss mindestens eines der Teilstrings mit Erde verbinden. Die Erdschließeinrichtung kann hierbei Schalter von den im Rahmen der Reihenschalteinrichtung aufgezählten Typen aufweisen, deren mögliche Anordnung in Einheiten im Wechselrichter, am Generator oder zwischen Generator und Wechselrichter derjenigen der Reihenschalteinrichtung oder der Parallelschalteinrichtung entspricht.

Die Erdschließeinrichtung wird typischerweise betätigt, wenn die Reihenschalteinrichtung die elektrische Verbindung zwischen benachbarten Teilstrings aufgetrennt hat. In diesem Zustand könnten je nach Vorhandensein oder Fehlen einer Erdung von Teilen der photovoltaischen Anlage auftretende Spannungen an den Teilstrings gegenüber Erde den Gefahrengrenzwert übersteigen. Dies wird durch Herstellen eines definierten Potenzials an einem Anschluss der Teilstrings mittels der Erdschließeinrichtung verhindert. Die Erdschließeinrichtung kann auch in Verbindung mit der Parallelschließeinrichtung aktiviert sein.

Es ist ebenfalls denkbar, über die Schalter der Erdschließeinrichtung jeweils beide Anschlüsse der Teilstrings gleichzeitig mit Erde zu verbinden, so dass die angeschlossenen Teilstrings in diesem Zustand über Erde kurzgeschlossen sind, wodurch ebenfalls eine Gefährdung durch die Generatorspannung ausgeschlossen ist. Ebenso kann ein sicherer Zustand durch Herstellen einer Verbindung mit Erde zwischen allen Teilstrings erreicht werden.

Die Reihenschalteinrichtung, die Parallelschalteinrichtung, die Erdschließeinrichtung, die Kurzschließeinrichtung und die DC-Trenneinrichtung werden von einer zentralen Steuereinrichtung abhängig vom Vorliegen eines Betriebszustandes oder Signals, welche einer Gefahrensituation zugeordnet sind, gesteuert. Hierzu kann die Steuereinrichtung dazu eingerichtet sein, Betriebszustände der photovoltaischen Anlage, die einem Gefahrenfall zugeordnet sind, beispielsweise gefahrentypische Schwankungen in den elektrischen Kenngrößen der photovoltaischen Anlage, zu erkennen. Sie kann aber auch zum Empfang eines einem Gefahrenfall zugeordneten Signals eingerichtet sein, das beispielsweise vom Wechselrichter erzeugt wird, zum Beispiel wenn der Wechselrichter eine Inselnetz-Situation erkennt, oder auch von einer separaten Sensoreinrichtung oder durch eine manuelle Notabschalteinrichtung. Eine Übertragung des Signals zur Steuereinrichtung kann mittels einer elektrischen Steuerleitung, einer drahtlosen Verbindung oder auch mittels einer Übertragung über die vorhandenen Gleichspannungs- oder Wechselspannungsleitungen an die Steuereinrichtung erfolgen. Als drahtlose Verbindung kommen hier einerseits Funkverbindungen in Frage, aber auch andere Möglichkeiten drahtloser Signalübertragung wie beispielsweise Infrarot, Schall, Ultraschall, mechanische Wirkübertrager, hydraulische Wirkübertrager oder pneumatische Wirkübertrager.

In einem erfindungsgemäßen Verfahren wird die Anlage zunächst bei einer Spannung des Generators oberhalb des Gefahrengrenzwertes betrieben. In diesem Betriebszustand arbeitet die Anlage typischerweise besonders effizient. Sobald ein Gefahrenfall detektiert wird, wird die Anlage auf eine Generatorspannung reduziert, die unterhalb des Gefahrengrenzwertes liegt.

Eine Gefahrensituation bzw. ein Gefahrenfall kann vorliegen, wenn eine Inselnetz-Situation eintritt, das heißt wenn der Wechselrichter vom Netz getrennt wird, oder das Netz abgeschaltet ist, wenn ein Lichtbogen oder ein Erdschluss in elektrischen Verbindungen der photovoltaischen Anlage erkannt wird oder wenn eine Generatortrenneinrichtung am Wechselrichter ausgelöst wird, z.B. ein sogenannter Electronic Solar Switch. Eine Gefahrensituation bzw. ein Gefahrenfall kann ebenfalls vorliegen, wenn eine manuelle Notabschalteinrichtung betätigt wird, wenn gefahrentypische Schwankungen in elektrischen Kenngrößen der photovoltaischen Anlage erkannt werden oder wenn externe Sensoren wie beispielsweise Temperaturfühler, Rauchmelder oder Infrarotdetektoren ansprechen. Sofern die photovoltaische Anlage in einer Datenverbindung zu benachbarten, weiteren photovoltaischen Anlagen oder Wechselrichtern oder zu anderen Kommunikationseinheiten steht, kann ein einer Gefahrensituation zugeordnetes Signal auch von einer Anlage zur nächsten übertragen werden, so dass die Anlagen gemeinsam auf die Gefahrensituation reagieren können.

Eine Fortführung der Einspeisung elektrischer Leistung in ein Netz, an das die photovoltaische Anlage angeschlossen ist, kann trotz Reduktion der Generatorspannung erreicht werden, indem die auf einen Wert unterhalb eines Gefahrengrenzwertes reduzierte Generatorspannung mittels eines Hochsetzstellers zunächst auf einen ausreichend hohen Gleichspannungswert angehoben wird, mit dem eine Wechselrichterbrücke die Wechselspannung zur Einspeisung in das Netz erzeugt. Zum Beispiel kann der Hochsetzsteller eine Generatorspannung kleiner 120 V auf eine Zwischenkreisspannung größer 325 V anheben, so dass die direkte Einspeisung elektrischer Leistung in ein öffentliches Netz möglich ist.

In einer bevorzugten Ausführungsform des erfindungsgemäßen Verfahrens werden die einzelnen Teilstrings des Generators beim Betrieb der photovoltaischen Anlage oberhalb des Gefahrengrenzwertes in einer Reihenschaltung betrieben, die beispielsweise durch die vorbeschriebene Reihenschalteinrichtung gewährleistet werden kann, während die reduzierte Generatorspannung dadurch erreicht wird, dass die Teilstrings in einer Parallelschaltung betrieben werden, die beispielsweise durch die vorbeschriebene Parallelschalteinrichtung gewährleistet werden kann. Hierbei wird bei Detektion des Gefahrenfalles zwischen Reihenschaltung und Parallelschaltung der Teilstrings gewechselt.

Optional kann das Verfahren zusätzlich um einen Verfahrensschritt erweitert sein, in dem in Reaktion auf die Detektion des Gefahrenfalles eine Herstellung einer elektrischen Verbindung mindestens eines Anschlusses mindestens eines der Teilstrings mit Erde erfolgt, wodurch ein definiertes Potenzial dieses Anschlusses gegenüber Erde hergestellt wird. Eine solche Verbindung mit Erde kann beispielsweise durch die vorbeschriebene Erdschließeinrichtung gewährleistet werden.

Gemäß einer weiteren Ausführungsform des Verfahrens kann die Generatorspannung durch die Spannungs- oder Stromregelung eines Wechselrichters auf eine Spannung unterhalb des Gefahrengrenzwertes geregelt werden.

In einer mit erwogenen Variante des erfindungsgemäßen Verfahrens wird die Regelung der Generatorspannung auf einen Wert unterhalb des Gefahrengrenzwertes dadurch erreicht, dass zumindest ein Teilstring des Generators kurzgeschlossen wird, gegebenenfalls auch über Erde. Dieses. Kurzschließen von zumindest einem Teil des Generators kann auch als zusätzliche Maßnahme erfolgen, nachdem die Generatorspannung zunächst auf einen Wert unterhalb des Gefahrengrenzwertes reduziert wurde, zum Beispiel wenn ein weiteres Einspeisen elektrischer Leistung in ein Netz nicht mehr möglich ist. In diesem Fall würde die Generatorspannung ohne ein Kurzschließen andernfalls möglicherweise auf Werte oberhalb des Gefahrengrenzwertes ansteigen. Das Kurzschließen kann hierbei zum Beispiel ausgelöst werden, wenn eine Inselnetz-Situation vom Wechselrichter detektiert wird.

Weitere Eigenschaften, Merkmale und Vorteile der Erfindung ergeben sich aus der nachfolgenden detaillierten Beschreibung von Ausführungsbeispielen der Erfindung anhand der beigefügten Zeichnungen.
Fig. 1 zeigt hierbei eine erfindungsgemäße photovoltaische Anlage mit einer zusätzlichen DC-Trenneinrichtung und einer zusätzlichen Kurzschließeinrichtung,
Fig. 2 zeigt eine weitere erfindungsgemäße photovoltaische Anlage mit einer zusätzlichen DC-Trenneinrichtung, einer zusätzlichen Kurzschließeinrichtung und einer zusätzlichen Erdschließeinrichtung,
Fig. 3 zeigt eine weitere erfindungsgemäße photovoltaische Anlage, bei der die Schaltelemente in gemeinsamen Einheiten im Wechselrichter angeordnet sind,
Fig. 4 zeigt eine weitere erfindungsgemäße photovoltaische Anlage, bei der die Schaltelemente in gemeinsamen Einheiten am Generator angeordnet sind,
Fig. 5 zeigt eine weitere erfindungsgemäße photovoltaische Anlage, bei der die Schaltelemente in separaten Einheiten zwischen jeweils zwei Teilstrings angeordnet sind,
Fig. 6 zeigt eine weitere erfindungsgemäße photovoltaische Anlage, bei der die Schaltelemente in separaten, jeweils einem Teilstring zugeordneten Einheiten angeordnet sind,
Fig. 7 zeigt eine weitere erfindungsgemäße photovoltaische Anlage, bei der die Schaltelemente in separaten, jeweils einem Teilstring zugeordneten Einheiten angeordnet sind,
Fig. 8 zeigt ein erfindungsgemäßes Verfahren zur Begrenzung der Generatorspannung im Gefahrenfall und
Fig. 9 zeigt beispielhafte Verläufe von Leistungskennlinien zur Illustration von Arbeitspunktverschiebungen.

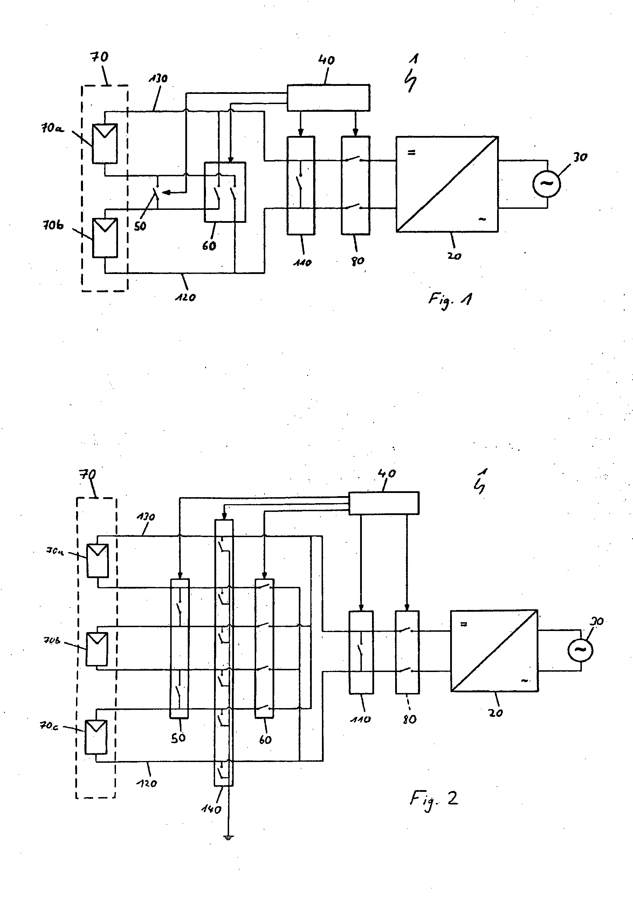

Fig. 1 zeigt einen erfindungsgemäßen Aufbau einer photovoltaischen Anlage 1 mit einem Wechselrichter 20, der wechselspannungsseitig an ein Netz 30, zum Beispiel ein öffentliches Wechselstromnetz angeschlossen ist. Auf der Gleichspannungsseite des Wechselrichters 20 ist dieser mittels Verbindungsleitungen 120, 130 mit einem Generator 70 verbunden. Der Generator 70 ist in zwei Teilstrings 70a, 70b unterteilt, die durch einen Schalter einer Reihenschalteinrichtung 50 miteinander in Reihe geschaltet werden können. Mittels einer Parallelschalteinrichtung 60 können die einzelnen Teilstrings zudem auch parallel zueinander geschaltet werden.

Die Ansteuerung der Reihenschalteinrichtung 50 und der Parallelschalteinrichtung 60 erfolgt hierbei über eine Steuereinrichtung 40 derart, dass im Normalbetrieb des Wechselrichters die Teilstrings 70a, 70b des Generators 70 in Reihenschaltung mit dem Wechselrichter 20 verbunden sind. Im Gefahrenfall steuert die Steuereinrichtung 40 die Reihenschalteinrichtung 50 so an, dass sie die elektrische Verbindung der beiden Teilstrings 70a, 70b auftrennt. Auf diese Weise wird erreicht, dass die Spannungen bzw. Spannungsdifferenzen in den Zuleitungen zum Generator 70 erheblich verringert werden, insbesondere dass bei entsprechender Auslegung der beiden Teilstrings 70a, 70b ausgeschlossen werden kann, dass eine bei Berührung für den Menschen gefährliche Spannung bzw. Spannungsdifferenz in den elektrischen Verbindungen des Generators 70 auftritt. Weiter steuert im Gefahrenfall die Steuereinrichtung 40 die Parallelschalteinrichtung 60 so an, dass sie die beiden Teilstrings 70a, 70b parallel zueinander schaltet. Dadurch fließt auch im Gefahrenfall weiterhin Strom zum Wechselrichter 20, allerdings auf einem niedrigeren Spannungsniveau. Der Generator 70 kann weiterhin elektrische Leistung über den Wechselrichter 20 in das Netz 30 einspeisen. Hierzu weist der Wechselrichter 20 typischerweise einen Hochsetzsteller (nicht gezeigt) auf, der die Betriebsspannung der parallel geschalteten Teilstrings 70a, 70b in eine ausreichend hohe Spannung zum Einspeisen von Leistung in das Netz 30 umwandeln kann.

Optional kann, wie im Ausführungsbeispiel der Fig. 1 gezeigt, zwischen den Verbindungsleitungen 120,130 eine Kurzschließeinrichtung 110 angeordnet sein, die ebenfalls von der Steuereinrichtung 40 angesteuert wird, und die im Gefahrenfall benutzt werden kann, um die Verbindungsleitung 120 mit der Verbindungsleitung 130 zu verbinden. Weiterhin kann die photovoltaische Anlage eine DC-Trenneinrichtung 80 in den Verbindungsleitungen 120,130 aufweisen, die ebenfalls von der Steuereinrichtung 40 gesteuert wird, um den Generator 70 von dem Wechselrichter 20 zu trennen.

Die Steuereinrichtung 40 ist dazu eingerichtet Betriebszustände der photovoltaischen Anlage zu analysieren oder ein von innerhalb oder außerhalb der photovoltaischen Anlage an die Steuereinrichtung übertragenes Signal zu empfangen. Insbesondere können die Signale beispielsweise von einem Not-Ausschalter oder von einer Überwachungskomponente der photovoltaischen Anlage erzeugt sein. Beim Erkennen eines Betriebszustandes, der einem Gefahrenfall zugeordnet ist, oder beim Empfang eines Signals, das einem Gefahrenfall zugeordnet ist, durch die Steuereinrichtung 40 löst diese eine entsprechende Ansteuerung der Schalter in der Reihenschalteinrichtung 50, der Parallelschalteinrichtung 60, der Kurzschließeinrichtung 110 und der DC-Trenneinrichtung 80 aus.

Figur 2 zeigt eine weitere Ausführungsvariante der erfindungsgemäßen Vorrichtung. Hier besteht der Generator 70 aus drei Teilstrings 70a, 70b, 70c, die mittels einer Reihenschalteinrichtung 50 miteinander in Serie geschaltet werden können. Mittels einer Parallelschalteinrichtung 60 können die einzelnen Teilstrings 70a, 70b, 70c parallel zueinander geschaltet werden. Mittels einer optionalen Erdschließeinrichtung 140 können Anschlüsse der Teilstrings weiterhin auch mit Erde verbunden werden. Die Reihenschalteinrichtung 50, die Parallelschalteinrichtung 60 und die Erdschließeinrichtung 140 werden durch die Steuereinrichtung 40 angesteuert. Auf diese Weise wird erreicht, dass sich im Normalbetrieb der photovoltaischen Anlage 1 die Betriebsspannungen der Teilstrings 70a, 70b, 70c zu einem Wert addieren lassen, der oberhalb der Scheitelspannung des an den Wechselrichter 20 angeschlossenen Netzes 30 liegt. Im Gefahrenfall kann durch ein Auftrennen der Reihenschaltung der Teilstrings 70a, 70b, 70c mittels der Reihenschalteinrichtung 50 und eine parallele Anordnung der Teilstrings 70a, 70b, 70c mittels der Parallelschalteinrichtung 60 erreicht werden, dass in den elektrischen Verbindungen zwischen dem Wechselrichter 20 und dem Generator 70 nur für den Menschen ungefährliche Spannungsdifferenzen auftreten können, und dass die photovoltaische Anlage gleichzeitig weiterhin Leistung ins Netz abgeben kann. Wie bereits im Zusammenhang mit dem Ausführungsbeispiel der Fig. 1 erwähnt, weist der Wechselrichter 20 hierzu typischerweise einen Hochsetzsteller (nicht gezeigt) auf, der die Betriebsspannung der parallel geschalteten Teilstrings 70a, 70b, 70c in eine ausreichend hohe Spannung zum Einspeisen von Leistung in das Netz 30 umwandeln kann. Auf diese Weise wird erreicht, dass die photovoltaische Anlage in einen berührungssicheren Zustand versetzt werden kann, ohne den Betrieb der Anlage vollständig einstellen zu müssen. Durch die Erdschließeinrichtung 140 kann dabei zusätzlich sichergestellt werden, dass an den Anschlüssen der Teilstrings definierte Potenziale gegenüber Erde vorliegen. Dies kann durch Betätigen der entsprechenden Schalter als Teilmenge der in Figur 2 gezeigten Schalter der Erdschließeinrichtung 140 bewerkstelligt werden. Es ist hierbei offenkundig, dass bei Verbinden beider Anschlüsse eines Teilstrings mit Erde dieser effektiv kurzgeschlossen werden kann. Bei der Ausführungsform gemäß Figur 2 sind alle Schalter der Erdschließeinrichtung über eine gemeinsame Leitung mit Erde verbunden. Alternativ kann auch jeder Schalter der Erdschließeinrichtung jeweils einzeln mit Erde verbunden sein.

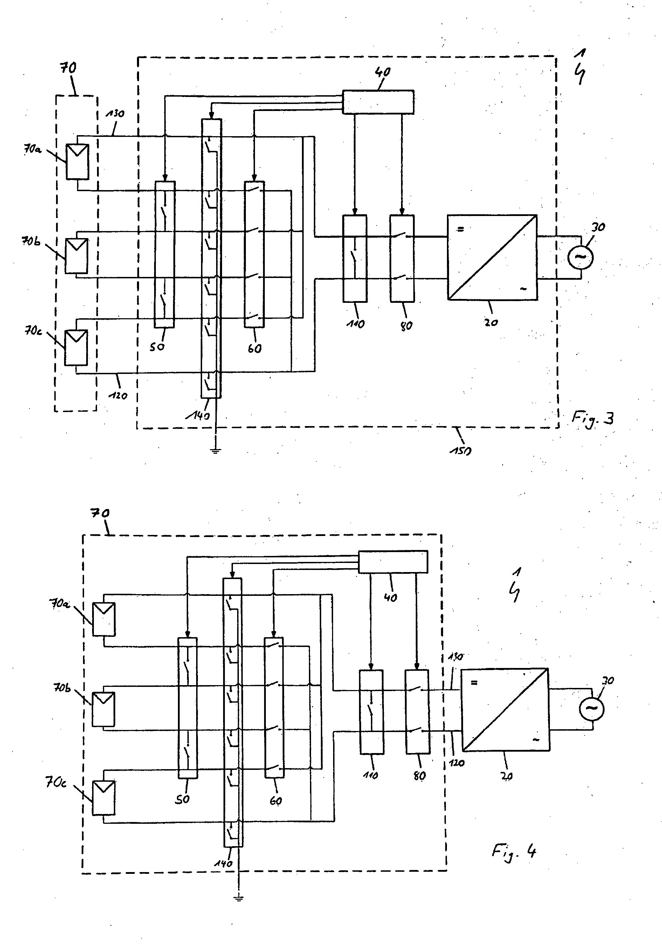

Figur 3 zeigt eine weitere Ausführungsvariante der erfindungsgemäßen Vorrichtung, bei der die Schaltelemente der Reihenschalteinrichtung 50, der Parallelschalteinrichtung 60 und der Erdschließeinrichtung 140 jeweils in einer gemeinsamen Einheit angeordnet sind. Bei der Ausführungsform gemäß Figur 3 sind jedoch jetzt die Reihenschalteinrichtung 50, die Parallelschalteinrichtung 60, die Erdschließeinrichtung 140, die Kurzschließeinrichtung 110, die DC-Trenneinrichtung 80 und die Steuereinrichtung 40 innerhalb eines Wechselrichtergehäuses 150 angeordnet, wodurch die Zuverlässigkeit der Funktion dieser Komponenten im Gefahrenfall erheblich erhöht wird.

Figur 4 zeigt eine weitere Ausführungsvariante der erfindungsgemäßen Vorrichtung, bei der die Schaltelemente der Reihenschalteinrichtung 50, der Parallelschalteinrichtung 60 und der Erdschließeinrichtung 140 jeweils in einer gemeinsamen Einheit angeordnet sind. Bei der Ausführungsform gemäß Figur 4 sind jedoch jetzt die Reihenschalteinrichtung 50, die Parallelschalteinrichtung 60, die Erdschließeinrichtung 140, die Kurzschließeinrichtung 110, die DC-Trenneinrichtung 80 und die Steuereinrichtung 40 am Generator angeordnet, insbesondere sind sie Bestandteile des Generators 70. Hierdurch wird der Verkabelungsaufwand für die photovoltaische Analage, insbesondere für die Verkabelung zwischen Generator 70 und Wechselrichter 20, gegenüber der Ausführungsvariante gemäß Figur 3 reduziert.

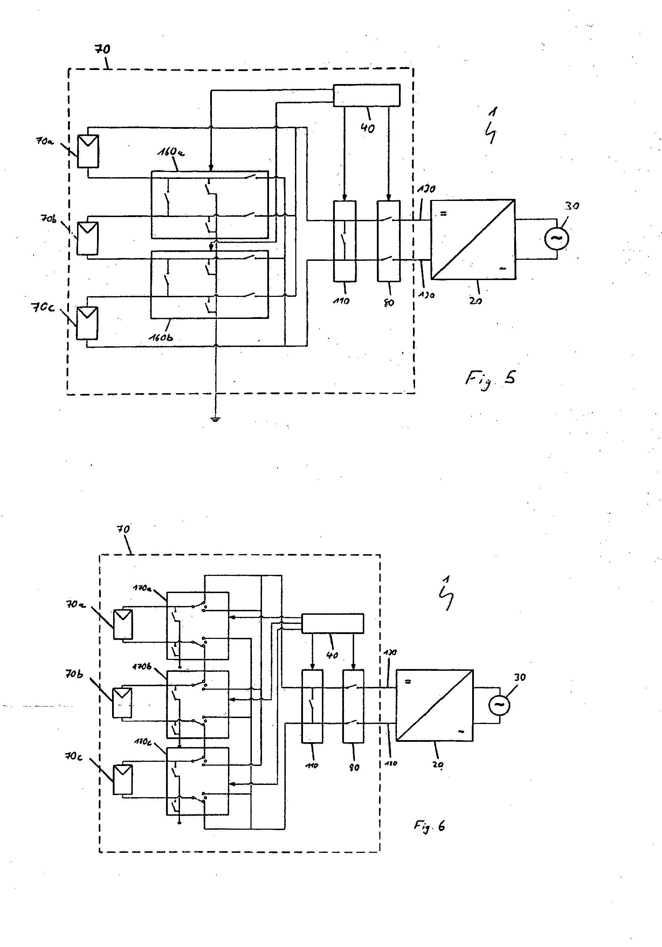

Figur 5 zeigt eine weitere Ausführungsvariante der erfindungsgemäßen Vorrichtung, bei der, wie schon in Figur 4, die Schaltelemente der Reihenschalteinrichtung, der Parallelschalteinrichtung und der Erdschließeinrichtung sowie die Kurzschließeinrichtung 110, die DC-Trenneinrichtung 80 und die Steuereinrichtung 40 am Generator angeordnet sind, insbesondere sind sie Bestandteile des Generators 70. Die Schaltelemente der Reihenschalteinrichtung, der Parallelschalteinrichtung und der Erdschließeinrichtung sind jedoch nicht jeweils in einer gemeinsamen Einheit angeordnet, wie bei der Ausführungsform in Figur 4, sondern in separaten Einheiten 160a, 160b zwischen jeweils zwei Teilstrings 70a, 70b, 70c, das heißt, jede separate Einheit ist mit je einem Anschluss benachbarter Teilstrings verbunden. Figur 5 zeigt auch, dass Ausführungsvarianten der erfindungsgemäßen Vorrichtung existieren, bei denen nicht alle Anschlüsse aller Teilstrings durch die optionale Erdschließeinrichtung mit Erde verbindbar sind.

Figur 6 zeigt eine weitere Ausführungsvariante der erfindungsgemäßen Vorrichtung, bei der die Schaltelemente Bestandteile des Generators 70 sind. Die Schaltelemente der Reihenschalteinrichtung, der Parallelschalteinrichtung und der Erdschließeinrichtung sind jetzt in separaten, jeweils einem der Teilstrings 70a, 70b, 70c zugeordneten Einheiten 170a, 170b, 170c angeordnet, das heißt, jede Einheit ist mit beiden Anschlüssen jeweils eines Teilstrings verbunden. Die Reihenschalteinrichtung und die Parallelschalteinrichtung sind hierbei unter Verwendung von Dreifachumschaltern ausgeführt, mit denen je nach Schalterstellung eine Reihenverschaltung, ein Auftrennen der Reihenverschaltung oder eine Parallelverschaltung der Teilstrings 70a, 70b, 70c realisiert werden kann. Anstelle der Dreifachumschalter können auch Verschaltungen von jeweils zwei einfachen Ein-Aus-Schaltern verwendet werden.

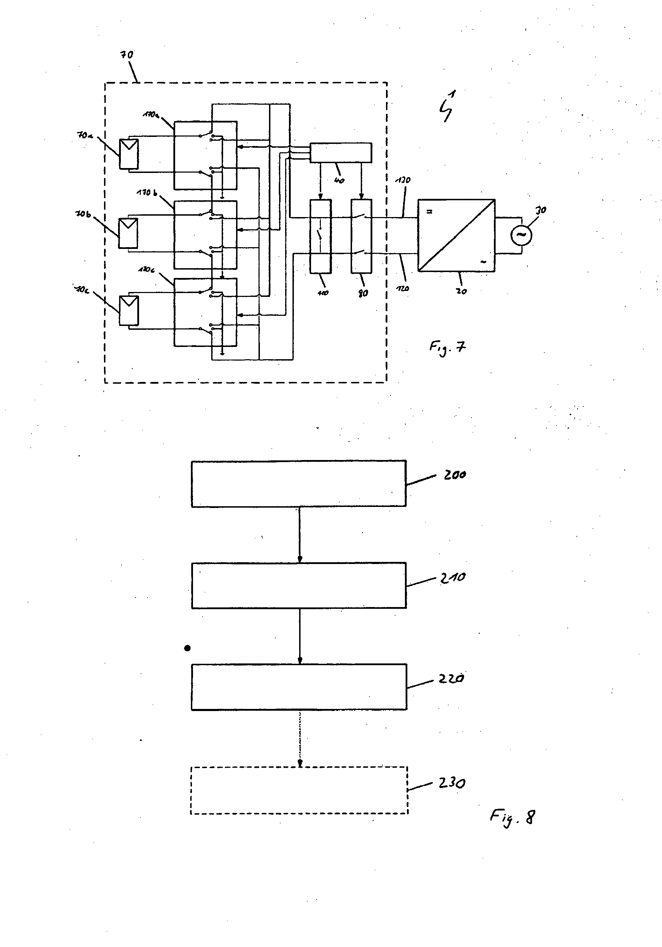

Figur 7 zeigt eine weitere Ausführungsvariante der erfindungsgemäßen Vorrichtung, bei der die Schaltelemente Bestandteile des Generators 70, das heißt am Generator angeordnet sind und bei der die Schaltelemente der Reihenschalteinrichtung, der Parallelschalteinrichtung und der Erdschließeinrichtung in separaten, jeweils einem der Teilstrings 70a, 70b, 70c zugeordneten Einheiten 170a, 170b, 170c angeordnet sind, das heißt, jede Einheit ist mit beiden Anschlüssen jeweils eines Teilstrings verbunden. Die Reihenschalteinrichtung, die Parallelschalteinrichtung und die Erdschließeinrichtung sind hier mit besonders geringem Aufwand unter Verwendung von Dreifachumschaltern ausgeführt. Bei dieser Ausführungsform sind jedoch insgesamt weniger Schaltzustände möglich als bei den zuvor gezeigten Ausführungsbeispielen, da je nach Schalterstellung entweder eine Reihenverschaltung der Teilstrings 70a, 70b, 70c oder einer Parallelverschaltung der Teilstrings 70a, 70b, 70c oder eine Verbindung der Anschlüsse der Teilstrings 70a, 70b, 70c mit Erde vorliegt. Diese Einschränkung kann ebenfalls durch den Einsatz von mehreren Ein-Aus-Schaltern anstelle der Umschalter überwunden werden.

Darüber hinaus sind viele weitere, hier nicht gezeigte Ausführungsvarianten der erfindungsgemäßen Vorrichtung möglich, von denen sich die meisten in einfacher Weise durch Variation und/oder Kombination der Anordnungen von Schaltern, Einheiten und Einrichtungen am Generator 70, im Wechselrichtergehäuse 150 oder zwischen Generator 70 und Wechselrichter 20 aus den zuvor aufgezeigten Ausführungsbeispielen ergeben. Weiterhin können durch eine Reihenschalteinrichtung in Serie geschaltete Teilstrings auch wieder parallel geschaltet werden, wodurch eine erfindungsgemäße Vorrichtung auch mehrere Reihenschalteinrichtungen, Parallelschalteinrichtungen, Erdschließeinrichtungen, Kurzschließeinrichtungen und DC-Trenneinrichtungen aufweisen kann.

Figur 8 zeigt ein Ablaufdiagramm entsprechend eines erfindungsgemäßen Verfahrens. In einem ersten Schritt 200 wird die photovoltaische Anlage bei einer Spannung des Generators 70 betrieben, die oberhalb eines Gefahrengrenzwertes liegt. Sobald ein Gefahrenfall detektiert wird (Schritt 210), wird die Spannung des Generators 70 auf einen Wert unterhalb des Gefahrengrenzwertes geregelt (Schritt 220). Die Regelung der Generatorspannung kann hierbei durch ein Umschalten der Reihenanordnung von Teilstrings 70a, 70b, 70c des Generators 70 in eine parallele Anordnung, zum Beispiel mittels der Reihenschalteinrichtung 50 und der Parallelschalteinrichtung 60, erfolgen. Alternativ kann die Regelung der Generatorspannung auch mittels geeigneter Ansteuerung eines Hochsetzstellers erfolgen, der Teil eines Wechselrichters ist, welcher zur Einspeisung der vom Generator 70 erzeugten Energie in ein Netz 30 vorgesehen ist. Optional kann in einem weiteren Verfahrensschritt 230 eine Herstellung einer elektrischen Verbindung mindestens eines Anschlusses mindestens eines der Teilstrings 70a, 70b, 70c mit Erde erfolgen.

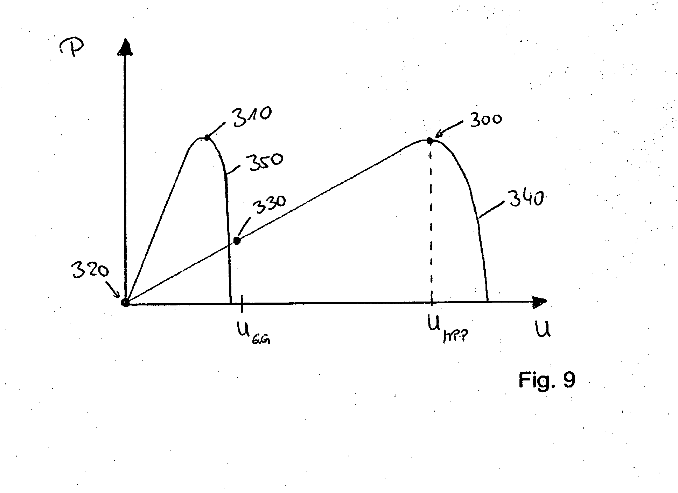

Figur 9 zeigt den Verlauf zweier Leistungskennlinien einer photovoltaischen Anlage als Funktion der Generatorspannung U. Eine erste Kurve 340 zeigt den Verlauf der Leistung P eines Generators in dem Fall, dass die Teilstrings in Serie geschaltet sind. Die maximale Leistung wird an einem Arbeitspunkt 300 erreicht, bei dem die Generatorspannung einen Wert U_{MPP} oberhalb eines Gefahrengrenzwertes U_{GG} aufweist. Wenn es aufgrund der Detektion einer Gefahrensituation notwendig wird, die Generatorspannung auf einen Wert unterhalb des Gefahrengrenzwertes U_{GG} zu regeln, kann der Arbeitspunkt des Generators beispielsweise zu einem Arbeitspunkt 330 verschoben werden, der knapp unterhalb des Gefahrengrenzwertes U_{GG} liegt, wobei die eingespeiste Leistung gegenüber der maximal möglichen Leistung am Arbeitspunkt 300 reduziert ist.

Wenn man die Teilstrings bei Detektion einer Gefahrensituation von einer Reihenschaltung in eine Parallelschaltung umkonfiguriert, ergibt sich eine zweite Leistungskennlinie 350, bei der die Generatorspannung in diesem Beispiel im gesamten Verlauf unterhalb des Gefahrengrenzwertes U_{GG} verbleibt. Hierdurch ist es möglich, den Generator weiterhin im Punkt maximaler Leistung 310 zu betreiben, so dass die Einspeisung elektrischer Energie im Wesentlichen unverändert gegenüber der Reihenschaltung erfolgen kann.

Sofern der Generator in Reihenschaltung verbleibt, das heißt im Gefahrenfall im Arbeitspunkt 330 betrieben wird, ist es erforderlich, bei Trennung des Wechselrichters vom Netz, oder in anderen Fällen, in denen eine weitere Einspeisung elektrischer Energie in das Netz nicht möglich ist, einen Arbeitspunkt zu erreichen, bei dem der Generator keine Leistung erzeugt und gleichzeitig die Generatorspannung unterhalb des Gefahrengrenzwertes U_{GG} liegt. Ein solcher Arbeitspunkt ist der Kurzschlusspunkt 320, der durch ein Kurzschließen des Generators erreicht werden kann.

### Bezugszeichenliste:

- 1: Photovoltaische Anlage
- 20: Wechselrichter
- 30: Netz
- 40: Steuereinrichtung
- 50: Reihenschalteinrichtung
- 60: Parallelschalteinrichtung
- 70: Generator
- 70a - 70c: Teilstrings
- 80: DC-Trenneinrichtung
- 110: Kurzschließeinrichtung
- 120: Verbindungsleitung
- 130: Verbindungsleitung
- 140: Erdschließeinrichtung
- 150: Wechselrichtergehäuse
- 160a, 160b: Einheiten zur Anordnung zwischen Teilstrings
- 170a - 170c: Einheiten zur Anordnung an Teilstrings
- 200, 210, 220: Verfahrensschritte
- 230: Verfahrensschritt
- 300: Erster Arbeitspunkt maximaler Leistung
- 310: Zweiter Arbeitspunkt maximaler Leistung
- 320: Kurzschlusspunkt
- 330: Dritter Arbeitspunkt
- 340: Erste Leistungskennlinie
- 350: Zweite Leistungskennlinie

## Patentansprüche

1. Photovoltaische Anlage (1) mit einem an einen Wechselrichter (20) angeschlossenen, eine Anzahl Teilstrings (70a, 70b, 70c) aufweisenden Generator (70), **dadurch gekennzeichnet, dass**
die photovoltaische Anlage (1) eine Reihenschalteinrichtung (50) zur Reihenverschaltung der Teilstrings (70a, 70b, 70c) und eine Parallelschalteinrichtung (60) zur Parallelverschaltung der Teilstrings (70a, 70b, 70c) aufweist, sowie eine Steuereinrichtung (40)zur Ansteuerung der Reihenschalteinrichtung (50)und der Parallelschalteinrichtung (60), wobei die Reihenschalteinrichtung (50) über die Steuereinrichtung (40) derart ansteuerbar ist, dass sie im Gefahrenfall die Reihenverschaltung der Teilstrings (70a, 70b, 70c)auftrennt, und die Parallelschalteinrichtung (60) über die Steuereinrichtung (40) derart ansteuerbar ist, dass sie im Gefahrenfall die Teilstrings (70a, 70b, 70c) parallel schaltet.

2. Photovoltaische Anlage gemäß Anspruch 1, **dadurch gekennzeichnet, dass** die photovoltaische Anlage (1) weiterhin eine Erdschließeinrichtung (140) aufweist, die über die Steuereinrichtung (40) derart ansteuerbar ist, dass sie im Gefahrenfall mindestens einen Anschluss mindestens eines der Teilstrings (70a, 70b, 70c) mit Erde verbinden kann.

3. Photovoltaische Anlage gemäß Anspruch 1 oder 2, **dadurch gekennzeichnet, dass** die Teilstrings (70a, 70b, 70c) derart dimensioniert sind, dass deren maximale Spannung kleiner als 120 Volt ist.

4. Photovoltaische Anlage gemäß einem der Ansprüche 1 bis 3, **dadurch gekennzeichnet, dass** die photovoltaische Anlage (1) weiterhin eine Kurzschließeinrichtung (110) aufweist, die über die Steuereinrichtung (40) ansteuerbar ist.

5. Photovoltaische Anlage gemäß einem der Ansprüche 1 bis 4, **dadurch gekennzeichnet, dass** die photovoltaische Anlage (1) weiterhin eine DC-Trenneinrichtung (80) aufweist, die über die Steuereinrichtung (40) ansteuerbar ist.

6. Photovoltaische Anlage gemäß einem der Ansprüche 1 bis 5, **dadurch gekennzeichnet, dass** die Steuereinrichtung (40) zur Erkennung eines einem Gefahrenfall zugeordneten Betriebszustandes der photovoltaischen Anlage eingerichtet ist.

7. Photovoltaische Anlage gemäß einem der Ansprüche 1 bis 6, **dadurch gekennzeichnet, dass** die Steuereinrichtung (40) zum Empfang eines einem Gefahrenfall zugeordneten Signals eingerichtet ist, das durch eine Steuerleitung, eine drahtlosen Verbindung oder durch Verbindungsleitungen (120, 130) zu den Teilstrings (70a, 70b, 70c) oder zu einem Netz (30) übertragen wird.

8. Verfahren zur Begrenzung einer Spannung eines Generators (70) einer photovoltaischen Anlage im Gefahrenfall, wobei das Verfahren die Schritte umfasst:
- Betrieb der photovoltaischen Anlage bei einer Generatorspannung oberhalb eines Gefahrengrenzwertes;
- Detektion eines Gefahrenfalles;
- Regelung der Generatorspannung auf einen Wert unterhalb des Gefahrengrenzwertes in Reaktion auf die Detektion des Gefahrenfalles durch Umschalten einer Reihenanordnung in eine Parallelanordnung von Teilstrings (70a, 70b, 70c) des Generators (70).

9. Verfahren gemäß Anspruch 8, **dadurch gekennzeichnet, dass** das Verfahren zusätzlich eine Herstellung einer elektrischen Verbindung mindestens eines Anschlusses mindestens eines Teilstrings (70a, 70b, 70c) mit Erde in Reaktion auf die Detektion des Gefahrenfalles umfasst.

10. Verfahren gemäß Anspruch 8 oder 9, **dadurch gekennzeichnet, dass** einer der folgenden Gefahrenfälle detektiert wird:
- Eintreten einer Inselnetzsitüation;
- Erkennung eines Lichtbogens in elektrischen Verbindungen der photovoltaischen Anlage (1);
- Erkennung eines Erdschlusses in elektrischen Verbindungen der photovoltaischen Anlage (1);
- Auslösen einer Generatortrenneinrichtung;
- Auslösen einer manuellen Notabschalteinrichtung;
- Ansprechen einer externen Sensoreinrichtung;
- Erkennung gefahrentypischer Veränderungen in den elektrischen Kenngrößen der photovoltaischen Anlage (1); und
- Empfang eines einem Gefahrenfall zugeordneten weiteren Signals von einer weiteren photovoltaischen Anlage oder einem weiteren Wechselrichter (20), mit der/dem die photovoltaische Anlage in einer Datenverbindung steht.

11. Verfahren gemäß einem der Ansprüche 8 bis 10, **dadurch gekennzeichnet, dass** der Gefahrengrenzwert zwischen 60 Volt und 150 Volt liegt.

12. Verfahren gemäß einem der Ansprüche 8 bis 11, **dadurch gekennzeichnet, dass** während der Regelung der Generatorspannung auf einen Wert unterhalb des Gefahrengrenzwertes die photovoltaische Anlage weiterhin eine Leistung in ein Netz (30) einspeist, an das die photovoltaische Anlage angeschlossen ist.

13. Verfahren gemäß einem der Ansprüche 8 bis 12, **dadurch gekennzeichnet, dass** die Regelung der Generatorspannung auf einen Wert unterhalb des Gefahrengrenzwertes ein Kurzschließen eines Teilstrings (70a, 70b, 70c) des Generators (70) umfasst.

## Claims

1. A photovoltaic installation (1), having a generator (70) that has a number of partial strings (70a, 70b, 70c) and is connected to an inverter (20), **characterized in that** the photovoltaic installation (1) is provided with a series-connection switching device (50) for the connection of the partial strings (70a, 70b, 70c) in series, and a parallel-connection switching device (60) for the connection of the partial strings (70a, 70b, 70c) in parallel, as well as a control device (40) for controlling the series-connection switching device (50) and the parallel-connection switching device (60), wherein the series-connection switching device (50) is controllable by the control device (40) such that it interrupts the series connection of the partial strings (70a, 70b, 70c) in case of a hazard, and the parallel-connection switching device (60) is contollable by the control device (40) such that it connects the partial strings (70a, 70b, 70c) in parallel in case of a hazard.

2. The photovoltaic installation as claimed in claim 1, **characterized in that** the photovoltaic installation (1) is further provided with a grounding device (140) that is controllable by the control device (40) such that, in case of a hazard, it can connect at least one of the terminals of at least one of the partial strings (70a, 70b, 70c) to ground.

3. The photovoltaic installation as claimed in claim 1 or 2, **characterized in that** the partial strings (70a, 70b, 70c) are dimensioned such that the maximum voltage thereof is lower than 120 volts.

4. The photovoltaic installation as claimed in one of claims 1 to 3, **characterized in that** the photovoltaic installation (1) is further provided with a short-circuiting device (110) that is controllable by means of the control device (40).

5. The photovoltaic installation as claimed in one of claims 1 to 4, **characterized in that** the photovoltaic installation (1) is further provided with a d.c. disconnecting device (80) that is controllable by means of the control device (40).

6. The photovoltaic installation as claimed in one of claims 1 to 5, **characterized in that** the control device (40) is configured for the detection of an operating state of the photovoltaic installation that is associated with a hazard condition.

7. The photovoltaic installation as claimed in one of claims 1 to 6, **characterized in that** the control device (40) is configured for the reception of a signal that is associated with a hazard condition, and that is transmitted via a control line, by wireless connection, or via connecting lines (120, 130) to the partial strings (70a, 70b, 70c) or to an electricity grid (30).

8. A method for limiting a voltage of a generator (70) of a photovoltaic installation in case of a hazard, wherein the method comprises the steps:
- Operation of the photovoltaic installation at a generator voltage that exceeds a hazard limit value;
- Detection of a hazard condition;
- Controlling the generator voltage to a value below the hazard limit value, in response to the detection of the hazard condition by switching the partial strings (70a, 70b, 70c) of the generator (70) from a series configuration to a parallel configuration.

9. The method as claimed in claim 8, **characterized in that** the method further comprises establishing an electrical connection between at least one of the terminals of at least one of the partial strings (70a, 70b, 70c) and ground, in response to the detection of a hazard condition.

10. The method as claimed in claim 8 or 9, **characterized in that** one of the following hazard conditions is detected:
- Occurrence of an islanding situation;
- Detection of an arc on the electrical lines of the photovoltaic installation (1);
- Detection of a ground fault on the electrical lines of the photovoltaic installation (1);
- Tripping of a generator disconnection device;
- Tripping of a manual emergency shutdown device;
- Response of an external sensor device;
- Detection of variations in electrical parameters of the photovoltaic installation (1) that are typically indicative of a hazard; and
- Reception of a further signal that is associated with a hazard condition from a further photovoltaic installation or a further inverter (20), the photovoltaic installation is connected to in a data network.

11. The method as claimed in one of claims 8 to 10, **characterized in that** the hazard limit value lies between 60 volts and 150 volts.

12. The method as claimed in one of claims 8 to 11, **characterized in that**, during the control of the generator voltage to a value that lies below the hazard limit value, the photovoltaic installation continues feeding electric power to an electricity grid (30), which the photovoltaic installation is connected to.

13. The method as claimed in one of claims 8 to 12, **characterized in that** the control of the generator voltage to a value below the hazard limit value comprises a short-circuiting of one of the partial strings (70a, 70b, 70c) of the generator (70).

## Revendications

1. Équipement photovoltaïque (1) comprenant un générateur (70) raccordé à un onduleur (20) et possédant une pluralité de chaînes partielles (70a, 70b, 70c), **caractérisé en ce que**
l'équipement photovoltaïque (1) possède un dispositif de branchement en série (50) destiné à connecter en série les chaînes partielles (70a, 70b, 70c) et un dispositif de branchement en parallèle (60) destiné à connecter en parallèle les chaînes partielles (70a, 70b, 70c), ainsi qu'un dispositif de commande (40) destiné à commander le dispositif de branchement en série (50) et le dispositif de branchement en parallèle (60), le dispositif de branchement en série (50) pouvant être commandé par le biais du dispositif de commande (40) de telle sorte qu'en cas de danger, il déconnecte la connexion en série des chaînes partielles (70a, 70b, 70c) et le dispositif de branchement en parallèle (60) pouvant être commandé par le biais du dispositif de commande (40) de telle sorte qu'en cas de danger, il connecte les chaînes partielles (70a, 70b, 70c) en parallèle.

2. Équipement photovoltaïque selon la revendication 1, **caractérisé en ce que** l'équipement photovoltaïque (1) possède en outre un dispositif de branchement à la terre (140) qui peut être commandé par le biais du dispositif de commande (40) de telle sorte qu'en cas de danger, il peut relier au moins une borne d'au moins l'une des chaînes partielles (70a, 70b, 70c) à la terre.

3. Équipement photovoltaïque selon la revendication 1 ou 2, **caractérisé en ce que** les chaînes partielles (70a, 70b, 70c) sont dimensionnées de telle sorte que leur tension maximale est inférieure à 120 volts.

4. Équipement photovoltaïque selon l'une des revendications 1 à 3, **caractérisé en ce que** l'équipement photovoltaïque (1) possède en outre un dispositif de court-circuit (110) qui peut être commandé par le biais du dispositif de commande (40).

5. Équipement photovoltaïque selon l'une des revendications 1 à 4, **caractérisé en ce que** l'équipement photovoltaïque (1) possède en outre un dispositif de déconnexion DC (80) qui peut être commandé par le biais du dispositif de commande (40).

6. Équipement photovoltaïque selon l'une des revendications 1 à 5, **caractérisé en ce que** le dispositif de commande (40) est conçu pour détecter un état de fonctionnement de l'équipement photovoltaïque qui est associé à une situation de danger.

7. Équipement photovoltaïque selon l'une des revendications 1 à 6, **caractérisé en ce que** le dispositif de commande (40) est conçu pour recevoir un signal associé à une situation de danger, lequel est transmis par le biais d'une ligne de commande, d'une liaison sans fil ou par le biais de lignes de liaison (120, 130) aux chaînes partielles (70a, 70b, 70c) ou à un réseau (30).

8. Procédé de limitation d'une tension d'un générateur (70) d'un équipement photovoltaïque en cas de danger, le procédé comprenant les étapes suivantes :
- fonctionnement de l'équipement photovoltaïque avec une tension de générateur supérieure à une valeur limite de danger ;
- détection d'une situation de danger ;
- régulation de la tension de générateur à une valeur inférieure à la valeur limite de danger en réaction à la détection de la situation de danger par permutation d'un arrangement en série en un arrangement en parallèle de chaînes partielles (70a, 70b, 70c) du générateur (70).

9. Procédé selon la revendication 8, **caractérisé en ce que** le procédé comprend en outre un établissement d'une liaison électrique d'au moins une borne d'au moins une chaîne partielle (70a, 70b, 70c) avec la terre en réaction à la détection de la situation de danger.

10. Procédé selon la revendication 8 ou 9, **caractérisé en ce que** l'une des situations de danger suivantes est détectée :
- survenance d'une situation de réseau en îlot ;
- détection d'un arc électrique dans des liaisons électriques de l'équipement photovoltaïque (1) ;
- détection d'un court-circuit à la terre dans des liaisons électriques de l'équipement photovoltaïque (1) ; ;
- déclenchement d'un dispositif de déconnexion du générateur ;
- déclenchement d'un dispositif de mise hors circuit d'urgence manuel ;
- activation d'un dispositif de détection externe ;
- détection de modifications typiques d'un danger dans les grandeurs caractéristiques électriques de l'équipement photovoltaïque (1) ; et
- réception d'un signal supplémentaire associé à une situation de danger de la part d'un équipement photovoltaïque supplémentaire ou d'un onduleur (20) supplémentaire avec lequel l'équipement photovoltaïque se trouve en communication de données.

11. Procédé selon l'une des revendications 8 à 10, **caractérisé en ce que** la valeur limite de danger est comprise entre 60 volts et 150 volts.

12. Procédé selon l'une des revendications 8 à 11, **caractérisé en ce que**, pendant la régulation de la tension du générateur à une valeur inférieure à la valeur limite de danger, l'équipement photovoltaïque continue d'injecter une puissance dans un réseau (30) auquel est raccordé l'équipement photovoltaïque.

13. Procédé selon l'une des revendications 8 à 12, **caractérisé en ce que** la régulation de la tension du générateur à une valeur inférieure à la valeur limite de danger comprend un court-circuit d'une chaîne partielle (70a, 70b, 70c) du générateur (70).
